# EUROPEAN PATENT APPLICATION

(11) **EP 4 770 385 A2**
(43) Date of publication of application: **01.07.2026**
(21) Application number: 25220830.1
(22) Date of filing: 04.12.2025
(51) Int. Cl.: H10K 59/18, H10H 29/80

(54) **TRANSPARENT DISPLAY DEVICE AND MANUFACTURING METHOD OF TILED DISPLAY DEVICE**

(30) Priority: 25.12.2024 US 202463738764 P; 30.06.2025 CN 202510889458
(71) Applicant: InnoLux Corporation, Jhu-Nan 350, Miao-Li County (TW)
(72) Inventor: CHUNG, Chuan-Han, 350 Miao-Li County (TW); TAI, Ming-Jou, 350 Miao-Li County (TW); CHANG, Chih-Hao, 350 Miao-Li County (TW); TSAI, Chia-Hao, 350 Miao-Li County (TW); WU, Yung-Hsun, 350 Miao-Li County (TW); CHANG, Chun-Hsiang, 350 Miao-Li County (TW); TU, Yu-Wei, 350 Miao-Li County (TW)
(74) Representative: Straus, Alexander

(57) **Abstract**

A transparent display device (1a) and a manufacturing method of a tiled display device (51) are provided. The transparent display device includes a substrate (12), a plurality of units (14), and a first alignment mark (M1). The substrate has a display region (DR). The units are disposed in the display region and repeatedly arranged in a first direction (X) and in a second direction (Y), and each of the units includes a pixel region (PXR) and a transparent region (TR1), in which each of the units includes at least one light-emitting element (16a) corresponding to the pixel region. The first alignment mark is disposed in the display region and formed of at least two pattern layers, in which at least one of the pattern layers includes metal, and in a top-view direction (Z), the first alignment mark is disposed in one of the units.

## Description

### Field of the Disclosure

The present disclosure relates to a transparent display device and a manufacturing method of a tiled display device and particularly to a transparent display device and a manufacturing method of a tiled display device with alignment marks.

### Background of the Disclosure

With the advancement of technology, transparent display devices have been developed that allow users to clearly view objects behind them. A traditional transparent display device needs a plurality of transparent regions to enable the users to view the objects through the transparent regions. Therefore, to improve visual effect of viewing the objects through the transparent display device is an objective in this field.

### Summary of the Disclosure

This in mind, the present disclosure aims at providing a transparent display device and a manufacturing method of a tiled display device to improve visual effect of the display device and the tiled display device.

This is achieved by a transparent display device and a manufacturing method of a tiled display device according to independent claims. The dependent claims pertain to corresponding further developments and improvements.

As will be seen more clearly from the detailed description following below, a transparent display device is provided by the present disclosure. The transparent display device includes a substrate, a plurality of units, and a first alignment mark. The substrate has a display region. The units are disposed in the display region and repeatedly arranged along a first direction and a second direction, and each of the units includes at least one pixel region and at least one transparent region, wherein each of the units includes at least one light-emitting element corresponding to the pixel region. The first alignment mark is disposed in the display region, and the first alignment mark is formed of at least two pattern layers, wherein one of the pattern layers includes metal, and in a top-view direction, the first alignment mark is disposed in one of the units.

As will be seen more clearly from the detailed description following below, a manufacturing method of a tiled display device is provided by the present disclosure. First, a first display panel and a second display panel are provided, wherein a manufacturing method of each of the first display panel and the second display panel includes providing a substrate having a display region; forming a plurality of first alignment marks in the display region; and forming at least one second alignment mark on the substrate. The step of forming the first alignment marks includes forming a plurality of first sub-marks on the substrate; providing a plurality of photomasks, and tiling the photomasks through the first sub-marks; and forming a plurality of second sub-marks on the first sub-marks. Then, the first display panel and the second display panel are tiled through the second alignment mark of the first display panel and the second alignment mark of the second display panel.

In the transparent display device and the manufacturing method of the tiled display device of the present disclosure, by disposing the first alignment mark in one unit, the impact of the first alignment mark on the visual effect may be reduced.

### Brief Description of the Drawings

In the following, the disclosure is further illustrated by way of example, taking reference to the accompanying drawings. Thereof
FIG. 1 schematically illustrates a top view of a transparent display device according to a first embodiment of the present disclosure,
FIG. 2 schematically illustrates a top view of the first alignment mark and a partial cross-sectional view of the transparent display device corresponding to the first alignment mark according to some embodiments,
FIG. 3 schematically illustrates a top view of the first alignment mark and a partial cross-sectional view of the transparent display device corresponding to the first alignment mark according to some embodiments,
FIG. 4 schematically illustrates a manufacturing method of a transparent display device according to a variant embodiment of the first embodiment of the present disclosure,
FIG. 5 schematically illustrates a top view of a transparent display device according to another variant embodiment of the first embodiment of the present disclosure,
FIG. 6 schematically illustrates a top view of a transparent display device according to a second embodiment of the present disclosure,
FIG. 7 schematically illustrates a top view of a transparent display device according to a variant embodiment of the second embodiment of the present disclosure,
FIG. 8 schematically illustrates a top view of a transparent display device according to a third embodiment of the present disclosure,
FIG. 9 schematically illustrates a top view of a transparent display device according to a variant embodiment of the third embodiment of the present disclosure,
FIG. 10 schematically illustrates a top view of a transparent display device according to another variant embodiment of the third embodiment of the present disclosure,
FIG. 11 schematically illustrates a top view of a transparent display device according to a fourth embodiment of the present disclosure,
FIG. 12 schematically illustrates a top view of a tiled display device according to a fifth embodiment of the present disclosure, and
FIG. 13 schematically illustrates a top view of a tiled display device according to a variant embodiment of the fifth embodiment of the present disclosure.

### Detailed Description

The contents of the present disclosure will be described in detail with reference to specific embodiments and drawings. It is noted that, for purposes of illustrative clarity and ease of understanding by the readers, the following drawings in the present disclosure are simplified schematic diagrams, and elements therein may not be drawn to scale. The numbers and sizes of the elements in the drawings are merely illustrative and are not intended to limit the scope of the present disclosure.

Certain terms are used throughout the specification and the appended claims of the present disclosure to refer to specific elements. Those skilled in the art should understand that electronic equipment manufacturers may refer to an element by different names, and this document does not intend to distinguish between elements that differ in name but not in function. In the following specification and claims, the terms "comprise", "include" and "have" are open-ended fashion, so they should be interpreted as "including but not limited to...".

The ordinal numbers used in the specification and the appended claims, such as "first", "second", etc., are used to describe the elements of the claims. This does not mean that the element has any previous ordinal numbers, nor does this represent the order of a certain element and another element, or the sequence in a manufacturing method. These ordinal numbers are merely used to make a claimed element with a certain name be clearly distinguishable from another claimed element with the same name.

Spatially relative terms, such as "above", "on", "beneath", "below", "under", "left", "right", "before", "front", "after", "behind" and the like, used in the following embodiments merely refer to the directions in the drawings and are not intended to limit the present disclosure.

In addition, when one element or layer is "on" or "above" another element or layer or is "connected to" the other element or layer, it may be understood that the element or layer is directly on the other element or layer or directly connected to the other element or layer, and alternatively, another element or layer may be between the element or layer and the other element or layer (indirectly). On the contrary, when the element or layer is "directly on" the other element or layer or is "directly connected to" the other element or layer, it may be understood that there is no intervening element or layer between the element or layer and the other element or layer. The term "electrically connected" or "coupled" includes means of direct or indirect electrical connection.

As disclosed herein, the terms "approximately", "essentially", "about", or "substantially" generally mean within 10%, 5%, 3%, 2%, 1%, or 0.5% of the reported numerical value or range. The quantity disclosed herein is an approximate quantity, that is, without a specific description of "approximately", "essentially", "about", or "substantially", the quantity may still include the meaning of "approximately", "essentially", "about", or "substantially".

It should be understood that, according to the following embodiments, features of different embodiments may be replaced, recombined or mixed to constitute other embodiments without departing from the spirit of the present disclosure. The features of various embodiments may be mixed arbitrarily and used in different embodiments without departing from or conflicting with the spirit of the present disclosure.

In the present disclosure, the thickness, area, width, height, and distance may be measured using an optical microscope (OM), a scanning electron microscope (SEM) or other approaches, and may be determined by the same picture or two or more pictures, but not limited thereto.

Unless otherwise defined, all terms (including technical and scientific terms) used herein have the same meaning as commonly understood by those skilled in the art. It should be understood that these terms, such as those defined in commonly used dictionaries, should be interpreted as having meaning consistent with the relevant technology and the background or context of the present disclosure, and should not be interpreted in an idealized or excessively formal way, unless there is a specific definition in the embodiments of the present disclosure.

A transparent display device and a tiled display device of the present disclosure may be applied to any kinds of electronic devices. The electronic device may be a bendable, stretchable, and/or flexible electronic device, but not limited thereto. The electronic device may, for example, include a sensing device, a light-emitting device, a display device, an antenna device, a touch device, a tiled device, or other suitable electronic devices, but not limited thereto. The sensing device may, for example, be a sensing device used for detecting variation in capacitances, light, heat, or ultrasound, but not limited thereto. The sensing device may, for example, include a bio-sensor, a touch sensor, a fingerprint sensor, other suitable sensors, or any combination of the aforementioned sensors. The display device may, for example, be applied to a laptop, a public display, a tiled display, a car display, a touch display, a TV, a monitor, a smartphone, a tablet, a light source module, a lighting equipment, or an electronic device applied to the aforementioned products, but not limited thereto. The display device may include a light-emitting element, a fluorescent material, a phosphor material, other suitable display media, or a combination thereof, but not limited thereto. The light-emitting element may, for example, include an organic light-emitting diode (OLED), a mini light-emitting diode (mini LED), a micro light-emitting diode (micro LED), or a quantum dot light-emitting diode (e.g., QLED or QDLED), but not limited thereto. The antenna device may include liquid crystal antenna or antennas of other types, but not limited thereto. The tiled device may, for example, include a tiled display device or a tiled antenna device, but not limited thereto. Furthermore, the appearance of the electronic device may be, for example, rectangular, circular, polygonal, a shape with curved edges, curved or other suitable shapes. The electronic device may have peripheral systems such as a driving system, a control system, a light source system, a shelf system, etc. The electronic device may include electronic elements, in which the electronic elements may include a passive element and an active element, and for example include a capacitor, a resistor, an inductor, a diode, a transistor, a sensor, etc. It is noted that the electronic device of the present disclosure may be any combination of the above-mentioned devices, but not limited thereto.

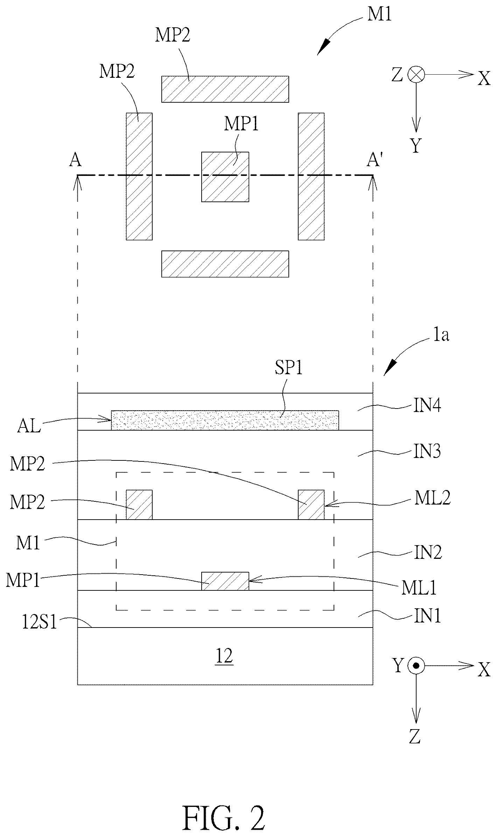

In the following drawings, direction X, direction Y, and direction Z are indicated. The direction Z may represent a normal direction of a transparent display device or a top-view direction. As shown in FIG. 2, the direction Z may be perpendicular to an upper surface 12S1 of a substrate 12. The direction X and the direction Y may be horizontal directions and may be perpendicular to the direction Z. As shown in FIG. 2, the direction X and the direction Y may be parallel to the upper surface 12S1 of the substrate 12, and the direction X and the direction Y may be perpendicular to each other. The spatial relationships of the structures in the following drawings may be described based on the direction X, the direction Y, and the direction Z.

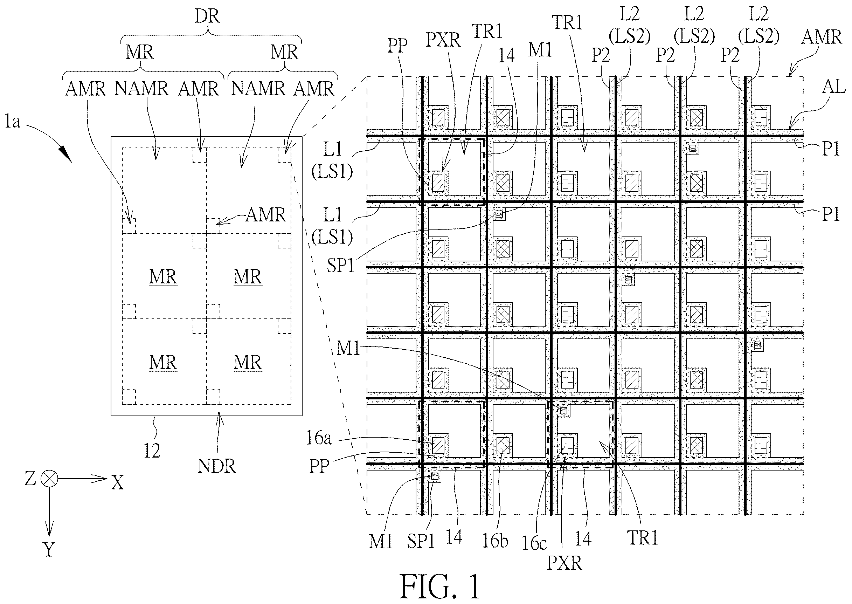

Refer to FIG. 1, which schematically illustrates a top view of a transparent display device according to a first embodiment of the present disclosure. As shown in FIG. 1, the transparent display device 1a includes a substrate 12, a plurality of units 14, and a first alignment mark M1. The substrate 12 has a display region DR, and the units 14 are disposed in the display region DR and repeatedly arranged along a first direction (e.g., the direction X) and a second direction (e.g., the direction Y). Each of the units 14 includes at least one pixel region PXR and at least one transparent region TR1. Each of the units 14 includes at least one light-emitting element (e.g., a light-emitting element 16a, a light-emitting element 16b, or a light-emitting element 16c) corresponding to the pixel region PXR. The first alignment mark M1 is disposed in the display region DR and is formed of at least two pattern layers, wherein at least one of the pattern layers includes metal. In a top-view direction (e.g., the direction Z), the first alignment mark M1 is disposed in one of the units 14.

In FIG. 1, the display region DR may include a plurality of photomask regions MR, and the photomask regions MR may be tiled together to form the display region DR, such that the elements in the display region DR may be formed by tiling different photomasks or by multiple exposures of the same photomask. In other words, the photomask regions MR may respectively correspond to different photomasks or to different exposure positions (or shots) of the same photomask. For example, the transparent display device 1a may have slight display non-uniformity (or shot mura) at boundaries between adjacent photomask regions MR, and a region of each photomask region MR may be determined by a region surrounded by the display non-uniformity boundary. It should be noted that since photomask with smaller size may have finer pattern, tiling the photomasks may help reduce critical dimension (CD) of elements in the display region DR, but the present disclosure is not limited thereto. In some embodiments, any pattern layer, such as a metal layer nearest the substrate 12, in the display region DR may be formed using a single photomask.

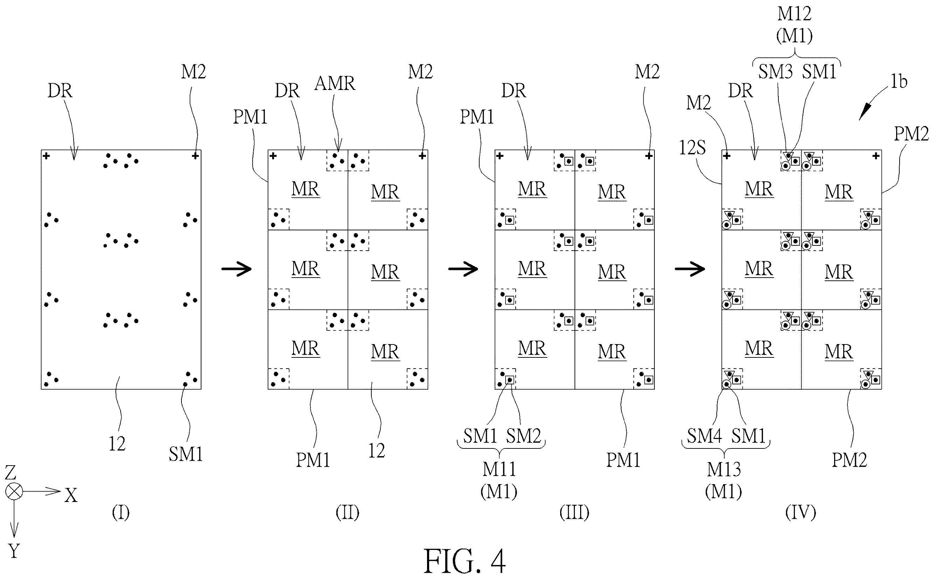

In FIG. 1, each of the photomask regions MR includes at least two alignment mark regions AMR, and an arranging direction of the alignment mark regions AMR may differ from the direction X and the direction Y, which allows the photomask to be aligned to one of the photomask regions MR of the substrate 12 in both direction X and direction Y. In this embodiment, the photomask region MR is exemplified as a rectangle, and the alignment mark regions AMR of each photomask region MR may be located at two non-adjacent corners of the corresponding photomask region MR. Furthermore, the arranging directions of the alignment mark regions AMR of different photomask regions MR may be the same, but not limited thereto. In some embodiments, the arranging directions of the alignment mark regions AMR of different photomask regions MR may be different. For example, one of the alignment mark regions AMR of one of the photomask regions MR on the left side may be adjacent to one of the alignment mark regions AMR of another of the photomask regions MR on the right side, so as to facilitate tiling of the photomasks corresponding to these two photomask regions MR, as shown in FIG. 4.

The right portion of FIG. 1 further schematically illustrates an enlarged view of the alignment mark region AMR. According to this embodiment, each alignment mark region AMR may include a plurality of first alignment marks M1, but not limited thereto. The structure of the first alignment mark M1 and the unit 14 will be further described below. As shown in the right portion of FIG. 1, the transparent display device 1a may further include a first wire group LS1 and a second wire group LS2 disposed in the display region DR. The first wire group LS1 extends along the first direction (e.g., the direction X), and the second wire group LS2 cross the first wire group LS1. In this embodiment, the transparent display device 1a may include a plurality of first wire groups LS1 and a plurality of second wire groups LS2. The first wire groups LS1 may be arranged along the second direction (e.g., the direction Y), and the second wire groups LS2 may extend along the direction Y and be arranged along the direction X. The first wire groups LS1 and the second wire groups LS2 may cross each other and electrically insulated from each other. Each first wire group LS1 may be composed of a single first wire L1, and each second wire group LS2 may be composed of a single second wire L2, but not limited thereto.

According to this embodiment, the transparent display device 1a may further include a plurality of light-emitting elements respectively disposed in the corresponding pixel regions PXR. The light-emitting elements may include, for example, a light-emitting element 16a, a light-emitting element 16b, and a light-emitting element 16c configured to respectively emit light of different colors, such as red, green, and blue light, or other suitable combinations of color light. The light-emitting element 16a, the light-emitting element 16b, and the light-emitting element 16c may serve as sub-pixels of different colors and may form a pixel, but not limited thereto. In some embodiments, at least two of the light-emitting elements 16a, the light-emitting element 16b, and the light-emitting element 16c may include light-emitting diodes of the same color combined with corresponding light conversion materials, and the light conversion materials may be adjusted according to the color of the light-emitting elements, but not limited thereto.

In the embodiment shown in FIG. 1, the light-emitting elements 16a, the light-emitting elements 16b, and the light-emitting elements 16c may be, for example, arranged in an array. The light-emitting elements 16a, the light-emitting elements 16b, and the light-emitting elements 16c in the same row may be sequentially and alternately arranged, and the light-emitting elements in the same column may be the light-emitting elements 16a, the light-emitting elements 16b, or the light-emitting elements 16c configured to emit the same color light. However, the arrangement of the light-emitting elements is not limited to that shown in FIG. 1. In some embodiments, the light-emitting elements 16a, the light-emitting elements 16b, and the light-emitting elements 16c configured to emit different color light may be sequentially and alternately arranged in the same column, and the light-emitting elements in the same row may be the light-emitting elements 16a, the light-emitting elements 16b, or the light-emitting elements 16c configured to emit the same color light. In some embodiments, each light-emitting element may be electrically connected to the corresponding first wire L1 and second wire L2 through other elements and/or traces, but not limited thereto. The other elements may include, for example, transistors or other suitable elements.

In this embodiment, the light-emitting elements in each row and each first wire group LS1 may be alternately arranged along the direction Y, and each second wire group LS2 and the light-emitting elements in each column may be alternately arranged along direction X, but not limited thereto. For example, the first wires L1 and the second wires L2 may respectively serve as scan lines and data lines, such that each first wire L1 may be used to transmit gate signals for controlling the switching of the corresponding light-emitting elements, and each second wire L2 may be used to transmit grayscale signals for the corresponding light-emitting elements. However, in some embodiments, the first wires L1 and the second wires L2 may alternatively respectively serve as the data lines and the scan lines, or other suitable combinations of signal lines. The first wires L1 and the second wires L2 of the present disclosure are not limited to be straight lines shown in FIG. 1. In some embodiments, extending directions of the first wire L1 and the second wire L2 may be adjusted according to requirements, such that the extending direction of the second wire L2 may not be perpendicular to that of the first wire L1, but not limited thereto.

As shown in the right portion of FIG. 1, each transparent region TR1 may be located between two adjacent first wire groups LS1 and between two adjacent second wire groups LS2, and each pixel region PXR may also be located between two adjacent first wire groups LS1 and between two adjacent second wire groups LS2. In this configuration, the unit 14 may serve as the smallest repeating structural unit in the transparent display device 1a, and each unit 14 may be located at an intersection of one of the first wire groups LS1 and one of the second wire groups LS2 and may include one transparent region TR1 and one pixel region PXR. The units 14 may be arranged, for example, in an array or other suitable configuration. In this case, each unit 14 may include a portion of the first wire group LS1 and a portion of the second wire group LS2. In each unit 14, the pixel region PXR may be located between the transparent region TR1 and the intersection of the first wire group LS1 and the second wire group LS2, but not limited thereto. In this embodiment, each unit 14 may include a portion of the first wire L1 and a portion of the second wire L2.

In the alignment mark region AMR, the first alignment marks M1 may be respectively disposed in the corresponding units 14. In the unit 14 with the first alignment marks M1 disposed therein, a ratio of an area of the first alignment mark M1 to an area of the corresponding unit 14 may be less than or equal to about 50%, or less than or equal to about 30%, so as to reduce the impact on visual effect. The first alignment marks M1 may be configured to, for example, align photomask or tile different transparent display devices. In this content, the first alignment marks M1 are exemplified for aligning photomask, but not limited thereto. In FIG. 1, the first alignment mark M1 may be located near the intersection of one of the first wire groups LS1 and one of the second wire groups LS2, so as to increase the area of the transparent region TR1, but not limited thereto. In some embodiments, the first alignment mark M1 may alternatively be located near an edge of one of the first wire groups LS1, an edge of one of the second wire groups LS2, a center of the transparent region TR1, or other suitable positions in the corresponding unit 14.

In FIG. 1, the alignment mark region AMR being a rectangle is taken as an example. The number of units 14 may be a product of the number of units 14 in the same row and the number of units 14 in the same column in the alignment mark region AMR. Furthermore, in the alignment mark region AMR, the number of first alignment marks M1 may be less than the number of units 14. For example, one of the units 14 may include one of the first alignment marks M1 to reduce the impact on visual effect. The number of first alignment marks M1 may be, for example, less than or equal to (m × n)/2, where m is the number of units 14 of the same row in the alignment mark region AMR, n is the number of units 14 of the same column in the alignment mark region AMR, and m and n are both greater than 1 and less than or equal to 6 (i.e., 1 < m, n ≤ 6). In FIG. 1, when there are 6 × 6 units 14 in the alignment mark region AMR, that is, m = n = 6, the number of first alignment marks M1 may be less than or equal to 18, but not limited thereto.

As shown in the right portion of FIG. 1, the alignment mark region AMR including 6 × 6 units 14 is as an example in this embodiment. When one of the units 14 in one row includes the first alignment mark M1, the other units 14 located on one or both sides of the unit 14 in the same row may not include the first alignment mark M1. Similarly, when one of the units 14 in a column of units 14 includes the first alignment mark M1, the other units 14 located on one or both sides of the unit 14 in the same column may also not include the first alignment mark M1. In other words, the arrangement of the first alignment marks M1 in the alignment mark region AMR may not have repetitive pattern and may be a random arrangement. However, the present disclosure is not limited thereto and may include other random arrangements. For example, the arranging direction of two adjacent first alignment marks M1 may differ from the direction X of the row of units 14 and the direction Y of the column of units 14. The above configuration of the first alignment marks M1 may help reduce their impact on the visual effect of the transparent display device 1a.

As shown in the right portion of FIG. 1, the transparent display device 1a may optionally further include an anti-reflection layer AL disposed on the substrate 12. Specifically, the anti-reflection layer AL may be disposed on the first wires L1 and the second wires L2 to mitigate reflection issues caused by the first wires L1, the second wires L2, and other elements, thereby improving visual effect. The anti-reflection layer AL may include, for example, a light-blocking material. The light-blocking material may include photoresist, ink, blackened metal layer, or other suitable materials. In some embodiments, the material of the anti-reflection layer AL may include molybdenum, titanium, chromium, silver, aluminum, gold, copper, oxides thereof, nitrides thereof, or combinations thereof, but not limited thereto. Specifically, the anti-reflection layer AL may have a mesh shape with a plurality of openings respectively corresponding to the transparent regions TR1. The transparent regions TR1 may be defined by the corresponding openings. In other words, the portions of the transparent display device 1a corresponding to the transparent regions TR1 may allow ambient light to pass through, enabling a user located on one side of the transparent display device 1a to view objects on the other side through the transparent regions TR1. In the embodiment of FIG. 1, the transparent regions TR1 may be arranged, for example, in an array or other suitable arrangement. In some embodiments, when the first wires L1 and the second wires L2 include blackened metal layers or have anti-reflection or light-absorbing materials formed on their upper surfaces, the transparent display device 1a may not include the anti-reflection layer AL.

Furthermore, the anti-reflection layer AL may include a plurality of first strip portions P1 and a plurality of second strip portions P2, wherein the first strip portions P1 extend along the direction X, and the second strip portions P2 extend along the direction Y. The first strip portions P1 may cross the second strip portions P2 to form a mesh shape. In this embodiment, the first strip portions P1 may respectively cover the first wires L1, and the second strip portions P2 may respectively cover the second wires L2, thereby mitigating reflection issues caused by the first wires L1 and the second wires L2 and improving visual effect. In FIG. 1, the anti-reflection layer AL may further include a plurality of pixel portions PP respectively located in the pixel regions PXR. In the direction Z, the pixel portion PP may, for example, surround the corresponding light-emitting element to shield wires and/or transistors electrically connected to the light-emitting element.

In this embodiment, the anti-reflection layer AL may be overlapped with the first alignment marks M1 to further reduce their impact on the visual effect of the transparent display device 1a. Specifically, the anti-reflection layer AL may include a plurality of block portions SP1 disposed in the alignment mark region AMR, and the block portions SP1 may respectively correspond to the first alignment marks M1, for example, covering the corresponding first alignment marks M1, but not limited thereto. In some embodiments, the anti-reflection layer AL may alternatively not include the block portions SP1.

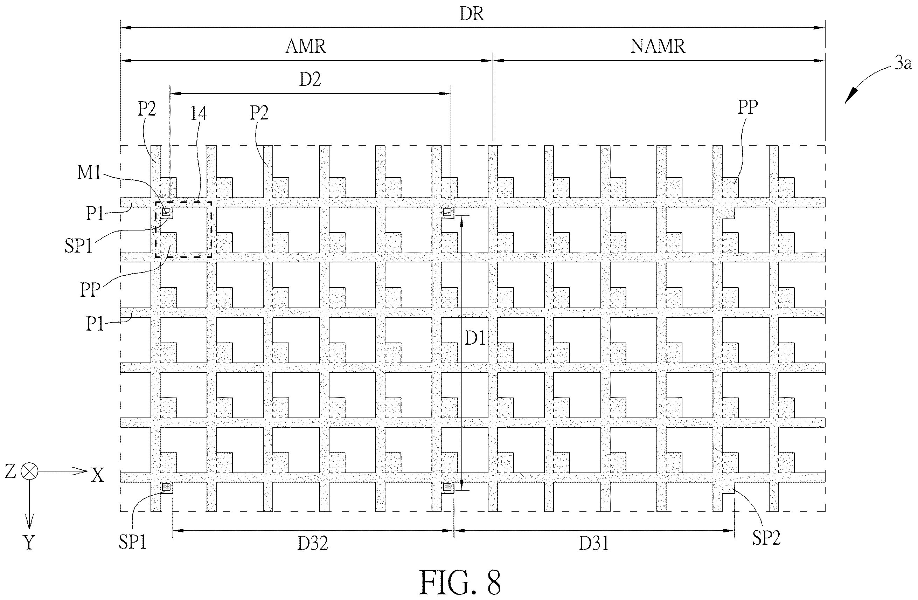

As shown in FIG. 1, the photomask region MR may further include a non-alignment mark region NAMR located outside the alignment mark regions AMR, and the non-alignment mark region NAMR is a region without alignment marks. According to this embodiment, the structure of the transparent display device 1a in the non-alignment mark region NAMR may also include the first wire groups LS1, the second wire groups LS2, the light-emitting elements, and the anti-reflection layer AL, which differs from that in the alignment mark region AMR in that it does not include the first alignment marks M1 and the block portions SP1. Other parts of the structure are the same as that in the alignment mark region AMR, so they are not detailed again. In some embodiments, the anti-reflection layer AL in the non-alignment mark region NAMR of FIG. 1 may also include block portions (e.g., block portions SP2 in FIG. 8). In this case, the block portions SP2 may have the same arrangement as the block portions SP1 to reduce visual difference between the alignment mark region AMR and the non-alignment mark region NAMR, but not limited thereto.

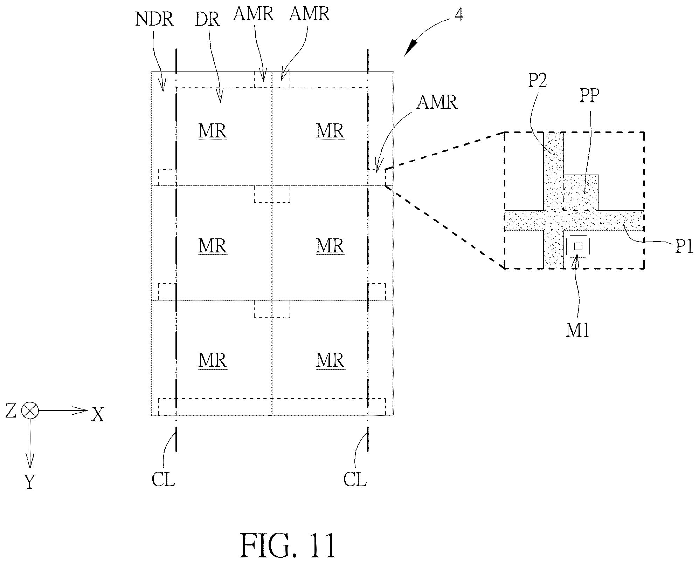

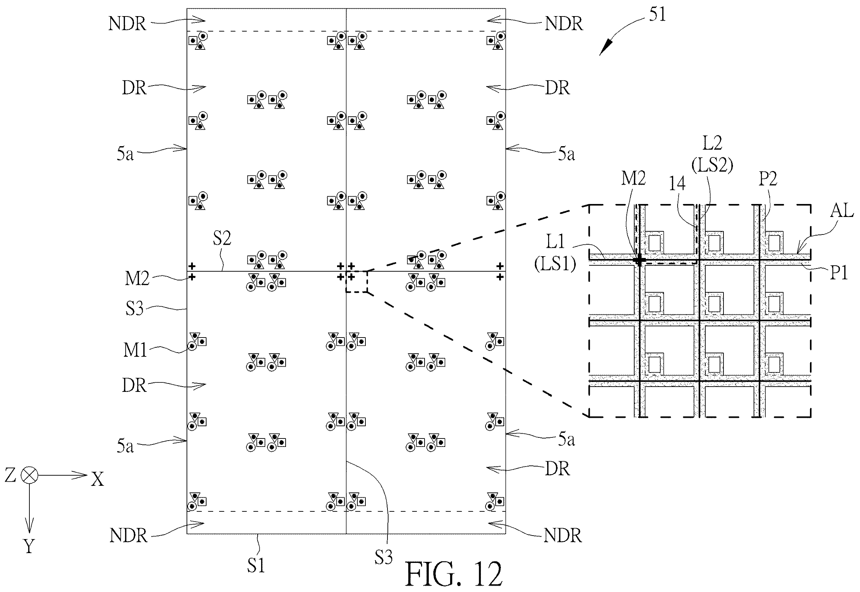

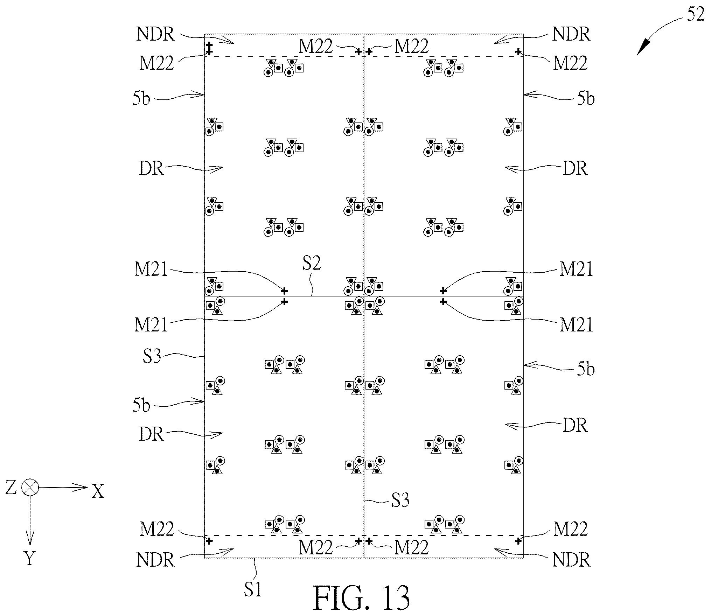

In the embodiment of FIG. 1, the substrate 12 may optionally further include a non-display region NDR disposed outside the display region DR for disposing peripheral circuits. The non-display region NDR may, for example, surround the display region DR, but not limited thereto. In some embodiments, the non-display region NDR may be disposed on one side of the display region DR (e.g., as shown in FIG. 12 or FIG. 13) or on three sides (e.g., as shown in FIG. 11), but not limited thereto.

The substrate 12 may include, for example, a rigid substrate or a flexible substrate. The rigid substrate may include, for example, glass, ceramic, quartz, or sapphire. The flexible substrate may include, for example, polyimide (PI), polycarbonate (PC) polyethylene terephthalate (PET), poly(methyl methacrylate) (PMMA), but not limited thereto.

Refer to FIG. 2, which schematically illustrates a top view of the first alignment mark and a partial cross-sectional view of the transparent display device corresponding to the first alignment mark according to some embodiments. The upper portion of FIG. 2 shows the top view of the first alignment mark, and the lower portion of FIG. 2 shows the cross-sectional view of the transparent display device taken along a line A-A' in the upper portion. As shown in FIG. 2, the transparent display device 1a may include the substrate 12, an insulating layer IN1, a metal layer ML1, an insulating layer IN2, a metal layer ML2, and an insulating layer IN3, which are sequentially disposed on the substrate 12. In FIG. 2, the metal layer ML1 may include a metal pattern MP1, and the metal layer ML2 may include a plurality of metal patterns MP2 that surround the metal pattern MP1 in the direction Z. The metal patterns MP2 may be separated from each other, but not limited thereto. In some embodiments, the metal patterns MP2 may be connected to form a ring. In the embodiment of FIG. 2, at least two pattern layers forming the first alignment marks M1 may each include metal, and the pattern layers may be, for example, the metal layer ML1 and the metal layer ML2, respectively. In other words, the first alignment mark M1 may be formed of the metal pattern MP1 of the metal layer ML1 and the metal patterns MP2 of the metal layer ML2, but not limited thereto. In some embodiments, the metal layer ML1 may include one of the first wire group and the second wire group, and the metal layer ML2 may include the other of the first wire group and the second wire group. That is, the first alignment mark M1 may be formed during the manufacturing process of the transparent display device 1a.

In some embodiments, the metal layer ML1 may alternatively be disposed above the metal layer ML2. Or, it is not limited to the single insulating layer IN2 between the metal layer ML1 and the metal layer ML2, and multiple insulating layers may be disposed between the metal layer ML1 and the metal layer ML2. The number of metal patterns MP2 may be, for example, four, but not limited thereto. In some embodiments, the first alignment mark M1 may not be limited to be formed of the metal pattern MP1 and the metal patterns MP2, and may further include at least one through hole in at least another insulating layer and/or at least one metal pattern in at least another metal layer. In some embodiments, different first alignment marks M1 may be distinguished, for example, by having different sizes or shapes of the metal patterns MP1 or having different widths or shapes of the metal patterns MP2.

As shown in FIG. 2, when the anti-reflection layer AL includes the block portion SP1, the block portion SP1 may be disposed, for example, on the insulating layer IN3. The transparent display device 1a may further optionally include an insulating layer IN4 disposed on the anti-reflection layer AL. The anti-reflection layer AL may be used to shield the first alignment marks M1 after the first alignment marks M1 are used, thereby reducing the impact of the first alignment marks M1 on visual effect. The first alignment mark M1 shown in FIG. 2 may be used to any of the embodiments of the transparent display device described above or below.

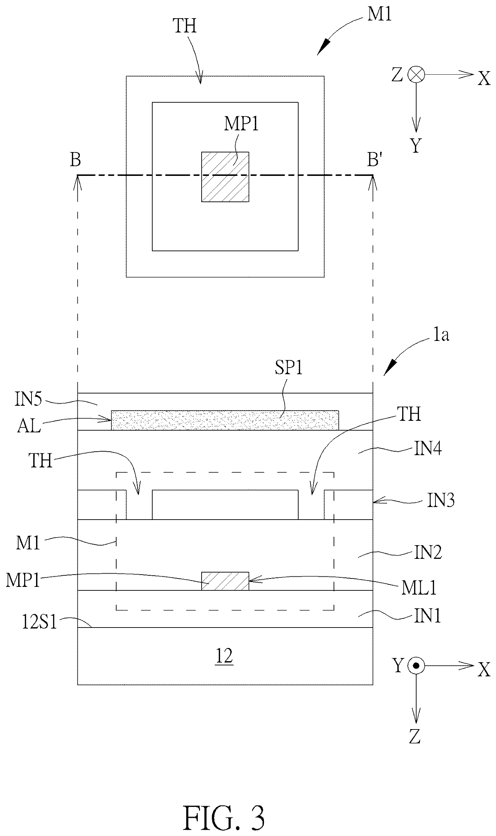

Refer to FIG. 3, which schematically illustrates a top view of the first alignment mark and a partial cross-sectional view of the transparent display device corresponding to the first alignment mark according to some embodiments. The upper portion of FIG. 3 shows the top view of the first alignment mark, and the lower portion of FIG. 3 shows the cross-sectional view of the transparent display device taken along a line B-B' in the upper portion. As shown in FIG. 3, the first alignment mark M1 of this embodiment differs from that of FIG. 2 in that the first alignment mark M1 may be formed by a through hole TH in the insulating layer and a metal pattern. Specifically, the transparent display device 1a may include the substrate 12, the insulating layer IN1, the metal layer ML1, the insulating layer IN2, and the insulating layer IN3 sequentially disposed on the substrate 12. In this embodiment, the metal layer ML1 may include the metal pattern MP1, and the insulating layer IN3 may include the through hole TH surrounding the metal pattern MP1 in the direction Z. At least one of the pattern layers forming the first alignment mark M1 may include metal, and another of the pattern layers may include the insulating material, such as the metal layer ML1 and the insulating layer IN3. In other words, the first alignment mark M1 may be formed of the metal pattern MP1 of the metal layer ML1 and the through hole TH of the insulating layer IN3, but not limited thereto. In some embodiments, the metal layer ML1 may be disposed below the insulating layer IN1 or above the insulating layer IN2 or the insulating layer IN3. Alternatively, the insulating layer IN3 may be directly disposed on the metal layer ML1 and in contact with it, meaning that the first alignment mark M1 does not include the insulating layer IN2. Alternatively, it is not limited to the single insulating layer IN2 between the metal layer ML1 and the insulating layer IN3, and there may be a plurality of insulating layers between them. In some embodiments, the first alignment mark M1 may not be limited to be formed of the metal pattern MP1 and the through hole TH, and may further include at least one through hole of another insulating layer and/or at least one metal pattern of another metal layer. In some embodiments, different first alignment marks M1 may be distinguished by having different sizes or shapes of the metal patterns MP1 or different widths or shapes of the through holes TH.

In FIG. 3, when the anti-reflection layer AL includes the block portion SP1, the anti-reflection layer AL may be disposed on the insulating layer IN4 and cover the first alignment mark M1. The transparent display device 1a may further optionally include an insulating layer IN5 disposed on the anti-reflection layer AL. The anti-reflection layer AL may be used to shield the first alignment mark M1 after the first alignment mark M1 is used, thereby reducing its impact on the user's visual experience. The first alignment mark M1 shown in FIG. 3 may be used to any of the embodiments of the transparent display device described above or below.

Refer to FIG. 4, which schematically illustrates a manufacturing method of a transparent display device according to a variant embodiment of the first embodiment of the present disclosure. The manufacturing method of the transparent display device 1b provided in this variant embodiment may include the following steps: providing the substrate 12; forming a plurality of first alignment marks M1 in the display region DR; and forming at least one second alignment mark M2 on the substrate 12. The step of forming the first alignment marks M1 may include forming a plurality of first sub-marks SM1 on the substrate 12; providing a plurality of photomasks PM1 and tiling the photomasks PM1 through the first sub-marks SM1; and forming a plurality of second sub-marks SM2 on the first sub-marks SM1. The manufacturing method disclosed herein is not limited to the above-mentioned steps and may include other steps performed before, after, or during any of the above-mentioned steps.

Specifically, as shown in FIG. 4, step (I) is first performed to form a plurality of first sub-marks SM1 in the display region DR of the substrate 12. In step (I) of this variant embodiment, at least one second alignment mark M2 may optionally be formed in the display region DR of the substrate 12. In FIG. 4, the number of second alignment marks M2 is exemplified as multiple, but not limited thereto. The first sub-marks SM1 and the second alignment marks M2 may be formed by patterning the same metal layer (e.g., the metal layer ML1 nearest the substrate 12 as shown in FIG. 2 or FIG. 3) using the same photomask. In other words, the first sub-marks SM1 and the second alignment marks M2 may be different metal patterns separated from each other in the same metal layer, but not limited thereto. The first sub-mark SM1 may be, for example, the metal pattern MP1 shown in FIG. 2 or FIG. 3, but not limited thereto. In some embodiments, the first sub-mark SM1 may alternatively be formed of a through hole in any insulating layer, but not limited thereto. In some embodiments, the first sub-mark SM1 and the second alignment mark M2 may be formed in different steps. In some embodiments, the second alignment mark M2 is not limited to be formed of single metal layer, and may be formed in any subsequent step.

Next, step (II) is performed to align the photomask PM1 to the substrate 12 using the first sub-marks SM1 and tile them. Each photomask PM1 may be aligned to the substrate 12 using the corresponding first sub-marks SM1 in two alignment mark regions AMR. Each photomask PM1 may define a corresponding photomask region MR, but not limited thereto. In this variant embodiment, the arranging directions of the alignment mark regions AMR corresponding to different photomasks PM1 may be different. For example, the alignment mark regions AMR in the left photomask region MR may be located at the lower-left and upper-right corners, while those in the right photomask region MR may be located at the upper-left and lower-right corners, such that the alignment mark region AMR at the upper-right corner of the left photomask region MR may be adjacent to the alignment mark region AMR at the upper-left corner of the right photomask region MR, thereby facilitating the tiling of the corresponding photomasks PM1.

Then, step (III) is performed to form the second sub-marks SM2 in the display region DR of the substrate 12 using the photomasks PM1, wherein at least one of the first sub-marks SM1 and at least one of the second sub-marks SM2 may together form at least one of the first alignment marks M11, but not limited thereto. In FIG. 4, the second sub-marks SM2 may be formed by patterning the same metal layer or insulating layer using the photomask PM1. In other words, the second sub-marks SM2 may respectively be, for example, the metal patterns MP2 shown in FIG. 2, the through holes TH of the insulating layer shown in FIG. 3, or other suitable structures.

After forming the second sub-marks SM2, step (IV) may be performed to repeat the step of aligning and tiling the photomasks and the step of forming the sub-marks using the photomasks. For example, another photomask may be used to form a plurality of third sub-marks SM3 on a portion of the first sub-marks SM1. Then, another photomask PM2 may be used to form a plurality of fourth sub-marks SM4 on the first sub-marks SM1, thereby forming a plurality of first alignment marks M1 in the display region DR to form the transparent display device 1b of this variant embodiment.

In FIG. 4, the third sub-marks SM3 and the fourth sub-marks SM4 may be, for example, metal patterns of a metal layer, through holes TH of an insulating layer, or other suitable structures. In other words, the first sub-marks SM1, second sub-marks SM2, third sub-marks SM3, and fourth sub-marks SM4 may be formed of different pattern layers, which may be metal layers or insulating layers. That is, the first sub-marks SM1, second sub-marks SM2, third sub-marks SM3, and fourth sub-marks SM4 may be formed of metal patterns of different metal layers or through holes of different insulating layers.

In this variant embodiment, the first alignment marks M1 may include the first alignment marks M11, the first alignment marks M12, and the first alignment marks M13. For example, at least one of the first sub-marks SM1 and at least one of the third sub-marks SM3 may form at least one first alignment mark M12, and at least one of the first sub-marks SM1 and at least one of the fourth sub-marks SM4 may form at least one first alignment mark M13, but not limited thereto. In some embodiments, at least one of the first alignment marks M1 may be formed of at least two of the first sub-mark SM1, the second sub-mark SM2, the third sub-mark SM3, and the fourth sub-mark SM4, but not limited thereto.

In FIG. 4, the first alignment mark M11, the first alignment mark M12, and the first alignment mark M13 may each be formed of at least two pattern layers, wherein at least one pattern layer of one of the first alignment mark M11, the first alignment mark M12, and the first alignment mark M13 may differ from that of another of the first alignment mark M11, the first alignment mark M12, and the first alignment mark M13. At least one pattern layer of the first alignment mark M11, the first alignment mark M12, and the first alignment mark M13 may include metal, and another pattern layer of them may include either metal or insulating material. In some embodiments, the first alignment mark M1 may be formed of more than two sub-marks. The step of forming sub-marks and the type, number and step of forming the alignment mark are not limited to those shown in FIG. 4, and may be adjusted as needed.

In some embodiments, as shown in FIG. 2 or FIG. 3, after the first alignment marks M1 are formed, an anti-reflection layer AL may be formed on the first alignment marks M1 to shield them. In some embodiments, the anti-reflection layer AL may shield the second alignment marks M2.

As shown in FIG. 4, it should be noted that the metal layers and insulating layers formed in step (I), step (II), step (III), and step (IV) may also include wires, portions of light-emitting elements, transistors, or other suitable elements in the transparent display device 1b. That is, the first alignment marks M1 and the second alignment marks M2 are formed during the manufacturing process of the transparent display device 1b. The difference between the transparent display device 1b of this variant embodiment and the transparent display device 1a of FIG. 1 is just in the arranging directions of the alignment mark regions AMR, and the manufacturing method of the transparent display device 1b may be used in the transparent display device 1a of FIG. 1 and any other embodiments described below.

In FIG. 4, both the first alignment marks M1 and the second alignment marks M2 are disposed in the display region DR, wherein at least one sub-mark of the first alignment mark M1 may be formed of a metal pattern of a metal layer, and the second alignment mark M2 may be formed of a metal pattern of at least one metal layer. In some embodiments, the substrate 12 may have an edge 12S, and a distance between one of the first alignment marks M1 (e.g., the first alignment mark M11) and the edge 12S in the direction X may be greater than a distance between the second alignment mark M2 and the edge 12S in the direction X, but not limited thereto. In some embodiments, the second alignment mark M2 may be disposed in the unit 14 different from the unit 14 for disposing the first alignment mark M1 in the top-view direction, as shown in FIG. 12.

The shape of the first alignment mark M1 may differ from that of the second alignment mark M2. The first alignment mark M1 may be used to align the photomasks, while the second alignment mark M2 may be used to align different transparent display devices when tiling them, but not limited thereto. In some embodiments, the top-view shapes of different sub-marks (e.g., the first sub-marks SM1, the second sub-marks SM2, the third sub-marks SM3, and the fourth sub-marks SM4) may be the same or different depending on the requirements, for example may include rectangle, circle, ring shape, triangle, or other suitable shapes. The sizes of different sub-marks may be adjusted to be the same or different as needed. In some embodiments, the top-view shape of the second alignment mark M2 may include, for example, a cross shape or other suitable shapes.

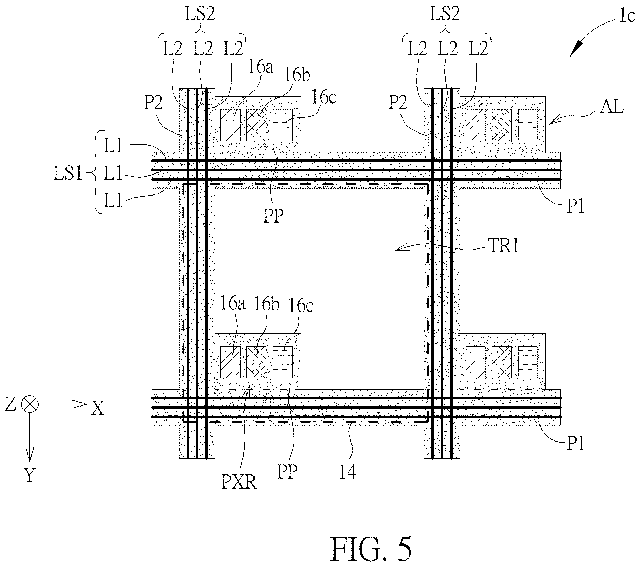

Refer to FIG. 5, which schematically illustrates a top view of a transparent display device according to another variant embodiment of the first embodiment of the present disclosure. A difference between the transparent display device 1c of this variant embodiment and the transparent display device 1a shown in FIG. 1 is that a plurality of light-emitting elements may be disposed in the same pixel region PXR. For example, the light-emitting element 16a, the light-emitting element 16b, and the light-emitting element 16c that form one pixel may be disposed in the same pixel region PXR, but not limited thereto. In this case, each first wire group LS1 may include three first wires L1, but not limited thereto. One of the first wire groups LS1 may be disposed between two adjacent pixel regions PXR in the direction Y, and the three first wires L1 may be electrically connected to the light-emitting element 16a, the light-emitting element 16b, and the light-emitting element 16c through transistors, respectively. Similarly, each second wire group LS2 may also include three second wires L2, but not limited thereto. One of the second wire groups LS2 may be disposed between two adjacent pixel regions PXR in the direction X, and the three second wires L2 may be electrically connected to the light-emitting element 16a, the light-emitting element 16b, and the light-emitting element 16c through transistors, respectively. In this embodiment, each unit 14 may include a transparent region TR1, a pixel region PXR, a portion of the first wire group LS1, and a portion of the second wire group LS2, but not limited thereto.

As shown in FIG. 5, when the transparent display device 1c includes the anti-reflection layer AL, the same pixel portion PP may surround the light-emitting element 16a, the light-emitting element 16b, and the light-emitting element 16c. Each first strip portion P1 may respectively cover the corresponding first wire group LS1, and each second strip portion P2 may respectively cover the corresponding second wire group LS2. Since other parts of the transparent display device 1c in this variant embodiment may be the same as those in the embodiment of FIG. 1, reference may be made to the above description, and further explanation is omitted here.

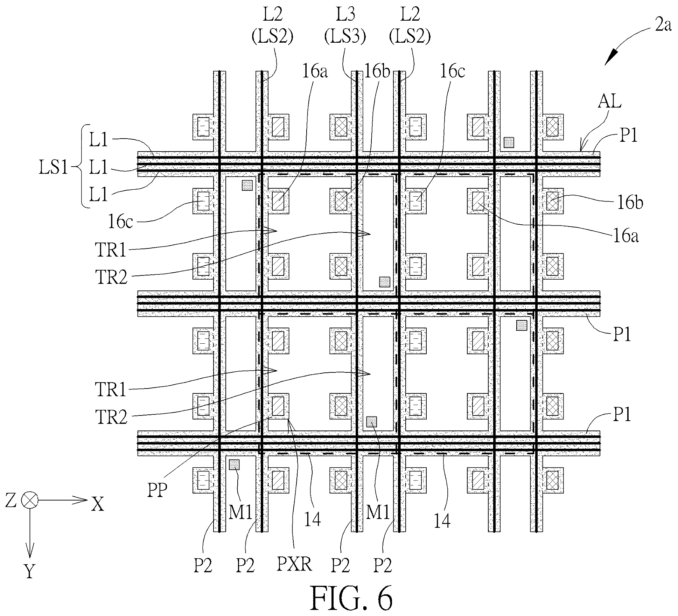

Refer to FIG. 6, which schematically illustrates a top view of a transparent display device according to a second embodiment of the present disclosure. As shown in FIG. 6, a difference between the transparent display device 2a provided in this embodiment and the transparent display device 1a of FIG. 1 is in the configuration relationship between the wire groups and the light-emitting elements. Specifically, the transparent display device 2a may include a plurality of first wire groups LS1, a plurality of second wire groups LS2, and a plurality of third wire groups LS3, wherein the third wire groups LS3 may cross and be insulated from the first wire groups LS1. The extending direction of the third wire groups LS3 may be the same as that of the second wire groups LS2, and the second wire groups LS2 and the third wire groups LS3 may be alternately arranged along the direction X. Furthermore, two adjacent rows of light-emitting elements may be disposed between two adjacent first wire groups LS1, and two adjacent columns of light-emitting elements and the transparent region TR1 may be disposed between one of the third wire groups LS3 and one of the second wire groups LS2 corresponding to the third wire group LS3, while the transparent regions TR2 may be disposed between the third wire group LS3 and another second wire group LS2 adjacent to the third wire group LS3. There is no light-emitting element disposed between the third wire group LS3 and the another second wire group LS2. In this case, the smallest repeating unit 14 may include four pixel regions PXR, the transparent regions TR1, the transparent region TR2, a portion of the first wire groups LS1, a portion of the second wire groups LS2, and a portion of the third wire groups LS3, wherein the transparent region TR1 may be greater than the transparent region TR2.

In this embodiment, each first wire group LS1 may include three first wires L1, each second wire group LS2 may be composed of a single second wire L2, and each third wire group LS3 may be composed of a single third wire L3, but not limited thereto. In some embodiments, when the transparent display device 2a includes the anti-reflection layer AL, each first strip portion P1 may cover three first wires L1, and each second strip portion P2 may cover one second wire L2 or one third wire L3. In the embodiment of FIG. 2, the first alignment mark M1 may be disposed in the transparent region TR2, but not limited thereto. In some embodiments, the first alignment mark M1 may be disposed in the transparent region TR1, but not limited thereto. In some embodiments, the anti-reflection layer AL may optionally include block portions (e.g., the block portion SP1 shown in FIG. 1) disposed corresponding to the first alignment marks M1.

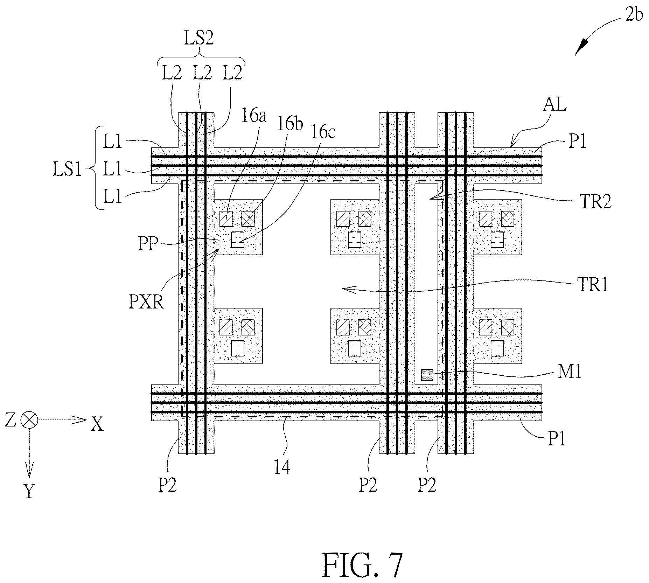

Refer to FIG. 7, which schematically illustrates a top view of a transparent display device according to a variant embodiment of the second embodiment of the present disclosure. A difference between the transparent display device 2b provided in this embodiment and the transparent display device 2a shown in FIG. 6 is that a plurality of light-emitting elements may be disposed in the same pixel region PXR. For example, the light-emitting element 16a, the light-emitting element 16b, and the light-emitting element 16c forming one pixel may be disposed in the same pixel region PXR, but not limited thereto. In this case, each second wire group LS2 may include three second wires L2, but not limited thereto. In some embodiments, when the transparent display device 2b includes the anti-reflection layer AL, each first strip portion P1 may cover three first wires L1, and each second strip portion P2 may cover three second wires L2. In some embodiments, the anti-reflection layer AL may optionally include a block portion (e.g., the block portion SP1 shown in FIG. 1) disposed corresponding to the first alignment mark M1.

Refer to FIG. 8, which schematically illustrates a top view of a transparent display device according to a third embodiment of the present disclosure. A difference between the transparent display device 3a provided in this embodiment and the transparent display device 1a shown in FIG. 1 is that the first alignment marks M1 may be arranged in a uniform arrangement, such as arranged in a spaced arrangement. In this embodiment, the distance D1 between portions (e.g., centers, top edges, or bottom edges) of two adjacent first alignment marks M1 arranged along the direction Y, corresponding to each other, may be, for example, five or other suitable times the width of the unit 14 in the direction Y, or there may be four units 14 between the two adjacent first alignment marks M1 in the direction Y. Similarly, the distance D2 between portions (e.g., centers, left edges, or right edges) of two adjacent first alignment marks M1 arranged along direction X, corresponding to each other, may be, for example, five or other suitable times the width of the unit 14 in the direction X, or there may be four units 14 between the two adjacent first alignment marks M1 in the direction X.

In some embodiments, the anti-reflection layer AL may optionally include a plurality of block portions SP1 respectively disposed corresponding to the first alignment marks M1, and the arrangement of the block portions SP1 may be the same as that of the first alignment marks M1. In this case, the anti-reflection layer AL in the non-alignment mark region NAMR may also include a plurality of block portions SP2, and the block portions SP2 may have the same arrangement as the block portions SP1. Furthermore, the distance D31 between corresponding portions of one of the block portions SP2 nearest the block portions SP1 and one of the block portions SP1 nearest the block portions SP2, arranged along the direction X, may be equal to the distance D32 between corresponding portions of two adjacent block portions SP1 arranged along the direction X. With this configuration, it may help reduce the transmittance difference between the alignment mark region AMR and the non-alignment mark region NAMR, thereby improving visual effect.

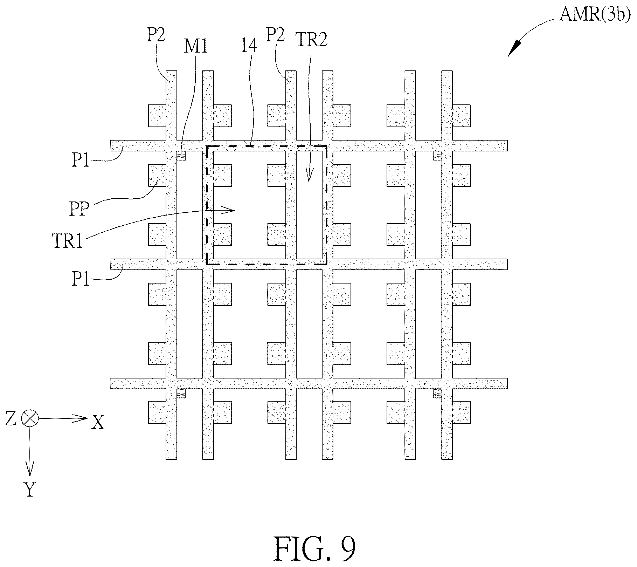

Refer to FIG. 9, which schematically illustrates a top view of a transparent display device according to a variant embodiment of the third embodiment of the present disclosure. A difference between the transparent display device 3b provided in this embodiment and the transparent display device 3a shown in FIG. 8 is that the configuration of the first wire groups, the second wire groups, and the light-emitting elements may adopt the configuration shown in FIG. 6 or FIG. 7. In this embodiment, the first alignment marks M1 may be arranged in a spaced or periodic arrangement, but not limited thereto. For example, the distance between corresponding portions of two adjacent first alignment marks M1 arranged along the direction X may be twice, or another suitable multiple of, the width of the unit 14 in the direction X, and the distance between corresponding portions of two adjacent first alignment marks M1 arranged along the direction Y may be twice, or another suitable multiple of, the width of the unit 14 in the direction Y, but not limited thereto. In some embodiments, the anti-reflection layer AL may optionally include a plurality of block portions (e.g., the block portions SP1 shown in FIG. 1) disposed corresponding to the first alignment marks M1, respectively. In some embodiments, the arrangement of the first alignment marks M1 in FIG. 9 may adopt the random arrangement shown in FIG. 1. In this case, the anti-reflection layer AL in the non-alignment mark region NAMR may optionally include a plurality of block portions SP2, and the block portions SP2 may have the same arrangement as the block portions SP1.

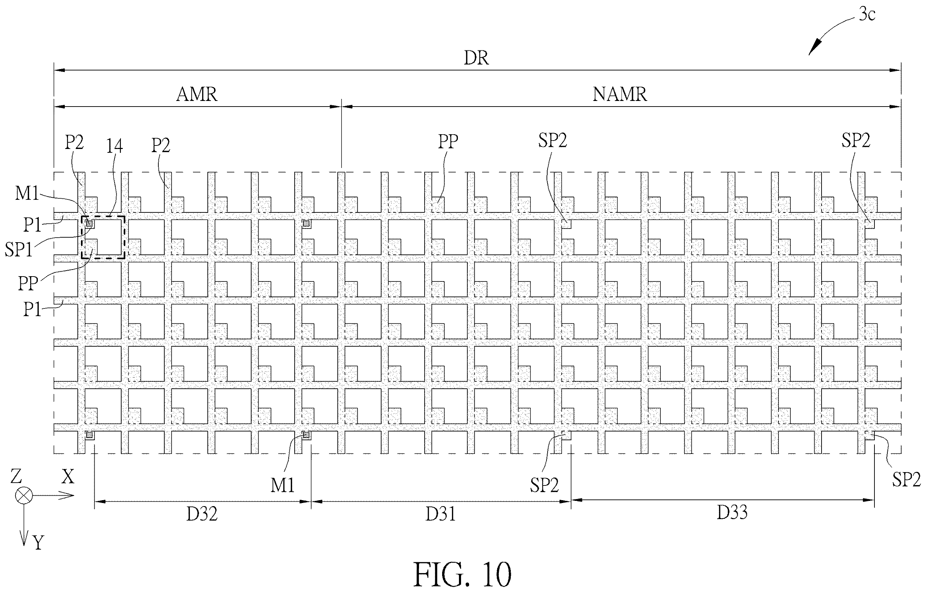

Refer to FIG. 10, which schematically illustrates a top view of a transparent display device according to another variant embodiment of the third embodiment of the present disclosure. A difference between the transparent display device 3c provided in this embodiment and the transparent display device 3a shown in FIG. 8 is that the distance D31 between corresponding portions of one of the block portions SP2 nearest the block portions SP1 and one of the block portions SP1 nearest the block portion SP2, arranged along the direction X, may be greater than the distance D32 between corresponding portions of two adjacent block portions SP1 along the direction X. Furthermore, the distance D33 between corresponding portions of two adjacent block portions SP2 arranged along the direction X in the non-alignment mark region NAMR may be greater than the above-mentioned distance D31. In other words, as the distance between the block portions and the alignment mark region AMR increases, the distance between two adjacent block portions may also increase, thereby reducing the transmittance difference between the alignment mark region AMR and the adjacent non-alignment mark region NAMR to improve visual effect. In some embodiments, the unit 14 in FIG. 10 may adopt the configuration shown in FIG. 6 or FIG. 7.

Refer to FIG. 11, which schematically illustrates a top view of a transparent display device according to a fourth embodiment of the present disclosure. A difference between the transparent display device 4 provided in this embodiment and the transparent display device 1a shown in FIG. 1 is that the non-display region NDR is disposed on three sides of the display region DR. In this embodiment, a portion of the alignment mark regions AMR may be located in the non-display region NDR to reduce the impact of the first alignment marks M1 on visual effect. In other words, a single photomask region MR may include portion of the non-display region NDR. In this case, when the alignment mark region AMR is located in the non-display region NDR, the structure of the anti-reflection layer AL corresponding to the first alignment mark M1 may be the same as that in the display region DR, thereby improving its alignment. That is, the anti-reflection layer AL may include a plurality of first strip portions P1, a plurality of second strip portions P2, and a plurality of pixel portions PP disposed in the non-display region NDR. As a result, the number of alignment mark regions AMR in the display region DR may be reduced to improve visual effect.

In FIG. 11, the transparent display device 4 may further include cutting lines CL extending along two opposite sides of the display region DR adjacent to the non-display region NDR, such that two sides of the transparent display device 4 may be borderless, but not limited thereto. In this case, after cutting, at least a portion of the photomask regions MR of the transparent display device 4 may each include only one alignment mark region AMR. In some embodiments, the cutting lines CL of the transparent display device 4 are not limited to those shown in FIG. 11, and the transparent display device 4 may further include another cutting line extending along a side of the display region DR adjacent to the non-display region NDR and connected to the two opposite sides, such that the transparent display device 4 may be a three-sided borderless display device, such as display panel 5a shown in FIG. 12 or FIG. display panel 5b shown in FIG. 13. In this case, after cutting, a portion of the photomask regions MR of the transparent display device 4 may include no alignment mark region AMR. In some embodiments, the configuration in which the alignment mark region AMR is disposed in the non-display region NDR and/or at least a portion of the photomask regions MR each includes only one or no alignment mark region AMR, as shown in FIG. 11, may be used to any of the embodiments described above or below.

The transparent display device may further include at least one second alignment mark (e.g., the second alignment mark M2 shown in FIG. 4, FIG. 12, or FIG. 13), such that different transparent display devices may be tiled together through the second alignment marks to form a tiled display device. These transparent display devices may have adjacent sides, and the second alignment marks may be disposed near each other to facilitate alignment during tiling. Following contents further detail embodiments of the tiled display device, but not limited thereto. Refer to FIG. 12, which schematically illustrates a top view of a tiled display device according to a fifth embodiment of the present disclosure. The tiled display device 51 provided in this embodiment may be formed by tiling a plurality of display panels 5a. The structure of the display panel 5a in the display region DR may be the same as that of the transparent display device 1b in FIG. 4, and will not be detailed herein. The reference may be made to the above description. In some embodiments, the display panel 5a may be replaced with any of the transparent display devices described above or other suitable display panels. Since the display panel 5a may be a transparent display device, the tiled display device 51 may be a tiled transparent display device, but not limited thereto. In this embodiment, the display panels 5a may be tiled together through the second alignment marks M2.

In this embodiment, the non-display region NDR of the display panel 5a may be disposed on one side of the display region DR, and the display panel 5a may include two second alignment marks M2 respectively located near two side edges of the display panel 5a, for example, at two corners of the display region DR away from the non-display region NDR. Specifically, the display panel 5a may include a side edge S1, a side edge S2, and two side edges S3, wherein the side edge S1 and the side edge S2 are opposite to each other, the side edge S1 is located in the non-display region NDR and away from the display region DR, and the two side edges S3 are opposite to each other and each is connected to the side edge S1 and the side edge S2. The second alignment marks M2 may be located at the corners respectively formed by the side edges S3 and side edge S2. In this case, the side edges S2 of two display panels 5a may be tiled together through the second alignment marks M2 located near the side edges S2, and the side edges S3 of two display panels 5a may be tiled side by side through the second alignment marks M2 located near the side edges S3, such that the tiled display device 51 may be formed by tiling the display panels 5a in an arrangement of 2×2 matrix. In some embodiments, the number of the second alignment marks M2 corresponding to the same tiling side edge S3 and/or side edge S2 may be more than two, and their number and positions are not limited to those shown in FIG. 12 and may be adjusted as needed. In some embodiments, the second alignment marks M2 of FIG. 12 or the display panel 5a may further include another second alignment mark M2 disposed at a corner of the display region DR near the non-display region NDR, that is the corner near the side edge S3 and the non-display region NDR. In some embodiments, the second alignment marks M2 of FIG. 12 or the display panel 5a may further include another second alignment mark M2 disposed at a corner of the non-display region NDR near the display region DR or at any position of the non-display region NDR near the side edge S3. In some embodiments, the second alignment marks M2 of FIG. 12 or the display panel 5a may further include another second alignment mark M2 disposed in an alignment mark region (e.g., the alignment mark region AMR shown in FIG. 1, FIG. 4, FIG. 8 to FIG. 11) and near the side edge S3 or the side edge S2.

In FIG. 12, the second alignment mark M2 may be overlapped with the first wire group LS1 and the second wire group LS2 to reduce its visual impact on the tiled display device 51. Especially, when four display panels 5a are tiled together, four second alignment marks M2 may be adjacent to each other. Therefore, the overlapping of the second alignment mark M2 with the first wire group LS1 and the second wire group LS2 may help reduce their visibility. The second alignment mark M2 may be disposed in one of the units 14 in the direction Z, but not limited thereto. In some embodiments, the anti-reflection layer AL may be overlapped with the second alignment mark M2. In other embodiments, the second alignment mark M2 may not be overlapped with the first wire group LS1 and the second wire group LS2.

A manufacturing method of the tiled display device 51 is further provided in this embodiment, which includes providing a plurality of display panels 5a and tiling the display panels 5a through the second alignment marks M2 of the display panels 5a. Since each display panel 5a may adopt any of the transparent display devices described above, the manufacturing method of each display panel 5a may be implemented with reference to the above descriptions. It should be noted that since the second alignment mark M2 may be formed of the metal layer nearest the substrate, it may be detected from the side of the substrate opposite to the second alignment mark M2 to perform alignment and tiling of the display panels 5a.

Refer to FIG. 13, which schematically illustrates a top view of a tiled display device according to a variant embodiment of the fifth embodiment of the present disclosure. A difference between the tiled display device 52 provided in this variant embodiment and the tiled display device 51 shown in FIG. 12 is that the display panel 5b may include a second alignment mark M21 located near the center of the side edge S2 and away from the corners of the display panels 5b, to reduce the impact of the second alignment mark M21 on the visual effect of the tiled display device 52. In some embodiments, the number of second alignment marks M2 corresponding to the same tiling side edge S2 and/or side edge S3 may be more than two. In some embodiments, the display panel 5b may alternatively be replaced with any of the transparent display devices described above or other suitable display panels.

In FIG. 13, each display panel 5b may further include two second alignment marks M22 respectively located at corners of the non-display region NDR near the side edges S3, such that the second alignment marks M22 may be used to tile the side edges S3 of two display panels 5b side by side. Other parts of the tiled display device and its manufacturing method in this variant embodiment may be the same as those in the embodiment of FIG. 12, and reference may be made to the above description. In some embodiments, the second alignment marks M21 and/or M22 in FIG. 13 may be combined with the second alignment marks M2 in FIG. 12. In other words, the display panel 5b in FIG. 13 may also include the second alignment marks M2 shown in FIG. 12.

In summary, in the transparent display device of the present disclosure, by disposing the first alignment mark in one unit, arranging the first alignment marks in a random or regular pattern, overlapping the first alignment marks with the anti-reflection layer, or disposing a portion of the alignment mark regions in the non-display region, the impact of the first alignment marks on the visual effect may be reduced. Additionally, the configuration of the second alignment marks described above may help reduce the impact of the second alignment marks on the visual effect of the tiled display device.

## Claims

1. A transparent display device (1a, 1b, 1c, 2a, 2b, 3a, 3b, 3c, 4), **characterized by:**
a substrate (12) having a display region (DR);
a plurality of units (14) disposed in the display region (DR) and repeatedly arranged along a first direction (X) and a second direction (Y), wherein each of the plurality of units (14) comprises at least one pixel region (PXR) and at least one transparent region (TR1), and each of the plurality of units (14) comprises at least one light-emitting element (16a, 16b, 16c) corresponding to the at least one pixel region (PXR); and
a first alignment mark (M1, M11) disposed in the display region (DR), wherein the first alignment mark (M1, M11) is formed of at least two pattern layers (ML1, IN3), one of the at least two pattern layers (ML1, IN3) comprises metal, and in a top-view direction (Z), the first alignment mark (M1, M11) is disposed in one of the plurality of units (14).

2. The transparent display device (1a, 1b, 1c, 2a, 2b, 3a, 3b, 3c, 4) according to claim 1, further comprising a second alignment mark (M2, M21, M22) disposed in the display region (DR) and formed of at least one metal layer, wherein the substrate (12) has an edge (12S), a distance between the first alignment mark (M1, M11) and the edge (12S) in the first direction (X) is greater than a distance between the second alignment mark (M2, M21, M22) and the edge (12S) in the first direction (X).

3. The transparent display device (1a, 1b, 1c, 2a, 2b, 3a, 3b, 3c, 4) according to claim 2, wherein a shape of the first alignment mark (M1, M11) is different from a shape of the second alignment mark (M2, M21, M22).

4. The transparent display device (1a, 1b, 1c, 2a, 2b, 3a, 3b, 3c, 4) according to claim 2 or 3, wherein the second alignment mark (M2, M21, M22) is disposed in another one of the plurality of units (14) in the top-view direction (Z).

5. The transparent display device (1a, 1b, 1c, 2a, 2b, 3a, 3b, 3c, 4) according to any one of claims 2-4, further comprising:
a first wire group (LS1) extending along the first direction (X); and
a second wire group (LS2) crossing the first wire group (LS1), wherein the second alignment mark (M2, M21, M22) is overlapped with the first wire group (LS1) and the second wire group (LS2).

6. The transparent display device (1a, 1b, 1c, 3a, 3c, 4) according to claim 5, wherein one of the plurality of units (14) comprises a portion of the first wire group (LS1) and a portion of the second wire group (LS2).

7. The transparent display device (2a, 2b, 3b) according to claim 5, further comprising a third wire group (LS3) crossing the first wire group (LS1), wherein one of the plurality of units (14) comprises a portion of the first wire group (LS1), a portion of the second wire group (LS2), and a portion of the third wire group (LS3).

8. The transparent display device (1a, 1b, 1c, 2a, 2b, 3a, 3b, 3c, 4) according to any one of claims 1-7, wherein the substrate (12) further has a non-display region (NDR) outside the display region (DR), and the transparent display device further comprises a second alignment mark (M2, M21, M22) disposed in the non-display region (NDR).

9. The transparent display device (1a, 1b, 1c, 2a, 2b, 3a, 3b, 3c, 4) according to any one of claims 1-8, further comprising another first alignment mark (M12) disposed in the display region (DR) and formed of at least two pattern layers, wherein at least one of the at least two pattern layers of the first alignment mark (M11) is different from the at least two pattern layers of the another first alignment mark (M12).

10. The transparent display device (1a, 1b, 1c, 2a, 2b, 3a, 3b, 3c, 4) according to claim 9, wherein the another first alignment mark (M12) is disposed in another of the plurality of units (14) in the top-view direction (Z).

11. The transparent display device (1a, 1b, 1c, 2a, 2b, 3a, 3b, 3c, 4) according to claim 10, wherein an arranging direction of the first alignment mark (M11) and the another first alignment mark (M12) is different from the first direction (X) and the second direction (Y).

12. The transparent display device (1a, 1b, 1c, 3a, 3c) according to any one of claims 1-11, further comprising an anti-reflection layer (AL) disposed on the substrate (12) and overlapped with the first alignment mark (M1).

13. The transparent display device (1a, 1b, 1c, 2a, 2b, 3a, 3b, 3c, 4) according to any one of claims 1-12, wherein a ratio of an area of the first alignment mark (M1) to an area of the one of the plurality of units (14) is less than or equal to 50%.

14. The transparent display device (1a, 1b, 1c, 2a, 2b, 3a, 3b, 3c, 4) according to any one of claims 1-13, wherein another of the at least two pattern layers of the first alignment mark (M1) comprises an insulating material or metal.

15. A manufacturing method of a tiled display device (51, 52), **characterized by:**
providing a first display panel (5a) and a second display panel (5b), wherein a manufacturing method of each of the first display panel (5a) and the second display panel (5b) comprises:
providing a substrate (12), wherein the substrate (12) has a display region (DR);
forming a plurality of first alignment marks (M1) in the display region (DR), wherein forming the plurality of first alignment marks (M1) comprises:
forming a plurality of first sub-marks (SM1) on the substrate (12);
providing a plurality of photomasks (PM1), and tiling the plurality of photomasks (PM1) through the plurality of first sub-marks (SM1); and
forming a plurality of second sub-marks (SM2) on the plurality of first sub-marks (SM1); and
forming at least one second alignment mark (M1) on the substrate (12); and
tiling the first display panel (5a) and the second display panel (5b) through the at least one second alignment mark (M2) of the first display panel (5a) and the at least one second alignment mark (M2) of the second display panel (5b).
